(19) Europäisches Patentamt
European Patent Office
Office européen des brevets

(11) **EP 0 986 174 B1**

(12) **EUROPÄISCHE PATENTSCHRIFT**

(45) Veröffentlichungstag und Bekanntmachung des Hinweises auf die Patenterteilung:
**08.02.2006 Patentblatt 2006/06**

(51) Int Cl.:
*H03K 5/24* *(2006.01)*    *H03F 3/45* *(2006.01)*
*H03F 1/02* *(2006.01)*

(21) Anmeldenummer: **99117881.5**

(22) Anmeldetag: **10.09.1999**

(54) **Komparator**

Comparator

Comparateur

(84) Benannte Vertragsstaaten:
**FR GB IT**

(30) Priorität: **11.09.1998 DE 19841718**

(43) Veröffentlichungstag der Anmeldung:
**15.03.2000 Patentblatt 2000/11**

(73) Patentinhaber: **STMicroelectronics GmbH**
**85630 Grasbrunn (DE)**

(72) Erfinder: **Heinrich, Peter**
**83024 Rosenheim (DE)**

(74) Vertreter: **Hirsch, Peter**
**Klunker Schmitt-Nilson Hirsch**
**Winzererstrasse 106**
**80797 München (DE)**

(56) Entgegenhaltungen:
**EP-A- 0 468 760        US-A- 4 442 408**
**US-A- 4 712 021        US-A- 5 148 119**
**US-A- 5 469 092        US-A- 5 543 976**

**Beschreibung**

Die Erfindung betrifft einen Komparator, der einen Differenzverstärker, einen mit einem Eingangssignal beaufschlagbaren Signaleingang und einen mit einer Referenzspannung beaufschlagbaren Referenzeingang aufweist. Zur Einstellung eines vorbestimmten Arbeitspunktes des Differenzverstärkers wird diesem ein Vorspannstrom zugeführt.

Bekanntlich ist die Schnelligkeit eines Komparators umso höher, je größer der Vorspannstrom ist. Das heißt, wie schnell es sich am Komparatorausgang auswirkt, wenn dessen Eingangssignal die Komparatorschwelle durchläuft, hängt von der Stärke des Vorspannstroms ab. Unter dem Gesichtspunkt der Schnelligkeit des Komparators wäre es daher erwünscht, ihm einen Vorspannstrom mit hoher Stromstärke zuzuführen. Das Dokument US-A-5 543 976 veröffentlicht einen Verstärker, dessen strom von der Frequenz des Eingangssignals abhängig ist.

Ein hoher Vorspannstrom führt aber zu einem entsprechend hohen Stromverbrauch, der insbesondere dann unerwünscht ist, wenn die Stromversorgung aus einer Batterie stattfindet.

Herkömmlicherweise muß man daher zu einem Kompromiß zwischen einem erträglichen Stromverbrauch und einer erträglichen Schnelligkeit des Komparators kommen.

Der Erfindung liegt die Aufgabe zugrunde, einen Komparator verfügbar zu machen, der diesem Kompromiß nicht unterliegt, sondern eine hohe Schnelligkeit bei niedrigem Stromverbrauch ermöglicht.

Diese Aufgabe wird gelöst mit einem Komparator gemäß Patentanspruch 1, der entsprechend den Ansprüchen 2 bis 9 weitergebildet werden kann.

Die Erfindung macht einen Komparator der eingangs angegebenen Art verfügbar, der eine steuerbare Vorspannstromquelle aufweist, mittels welcher ein Vorspannstrom zuführbar ist, der in Abhängigkeit davon, ob das Eingangssignal gerade konstant oder veränderlich ist, eine niedrige Ruhestromstärke oder eine höhere Aktivstromstärke aufweist.

Dieser erfindungsgemäßen Lösung liegt die Idee zugrunde, daß bei sehr vielen Anwendungen, insbesondere im digitalen Bereich, die Schnelligkeit des Komparators nur während solcher Zeiten gefragt ist, während welcher sich das Eingangssignal ändert, daß aber in den Zeiten dazwischen, während welcher das Eingangssignal konstant bleibt, der Komparator praktisch beliebig langsam sein kann. Während der Zeiten konstanten Eingangssignals wird somit nur ein sehr geringer Vorspannstrom benötigt und erfindungsgemäß auch nur geliefert. Während Zeiten sich ändernden Eingangssignals, während welcher es auf Schnelligkeit des Komparators ankommt, wird der Vorspannstrom erhöht, um die dann gewünschte Schnelligkeit des Komparators sicherzustellen. Da bei dieser erfindungsgemäßen Lösung ein hoher Vorspannstrom nur während Zeiten sich ändernden Eingangssignals fließt, während der restlichen Zeiten konstanten Eingangssignals, die im allgemeinen zeitlich sehr weit überwiegen, nur ein sehr geringer Vorspannstrom, wird erfindungsgemäß ein relativ niedriger mittlerer Stromverbrauch erzielt und zu den entscheidenden Zeiten trotzdem eine hohe Schnelligkeit des Komparators sichergestellt.

Bei einer Ausführungsform der Erfindung enthält die steuerbare Vorspannstromquelle zwei Stromquellen, deren Summenstrom dem Differenzverstärker als Vorspannstrom zugeführt wird. Eine der beiden Stromquellen ist eine Konstantstromquelle, die einen sehr niedrigen Ruhestrom, vorzugsweise im Bereich weniger μA liefert. Die andere Stromquelle ist eine Zusatzstromquelle, die einen Zusatzstrom nur während derjenigen Zeiten liefert, während welcher sich das Eingangssignal ändert.

Betrachtet man als Eingangssignal beispielsweise ein digitales Signal, das zwischen einem konstanten niedrigen Potential und einem konstanten hohen Potential wechselt, wobei die Übergänge zwischen dem niedrigen Potential und dem hohen Potential durch ansteigende oder abfallende Flanken bestimmter Flankenneigung gebildet werden, liefert die Zusatzstromquelle einen zusätzlichen Vorspannstrom nur während der Zeiten der Anstiegs- und Abfallflanken, während der zusätzliche Vorspannstrom zwischen den Flanken, also während der Zeitabschnitte gleichbleibenden niedrigen oder gleichbleibenden hohen Potentials null ist und während dieser Zeiten als Vorspannstrom nur der Ruhestrom der Konstantstromquelle geliefert wird. Während der Signalflanken ist der Komparator aufgrund des zusätzlichen Vorspannstroms schnell, während er während der Zeitabschnitte gleichbleibenden Potentials langsam ist und auch nur langsam zu sein braucht.

Bei einer besonders bevorzugten Ausführungsform der Erfindung wird während Zeiten, während welcher sich das Eingangssignal ändert, die Stärke des Zusatzstroms von der Stärke der Eingangssignaländerung abhängig gemacht. Dies führt dazu, daß der Komparator umso schneller ist, je steiler die Eingangssignaländerung ist. Die Schnelligkeit des Komparators wird somit an den Schnelligkeitsbedarf angepaßt. Wird bei sehr schneller oder sehr steiler Eingangssignaländerung sehr hohe Schnelligkeit des Komparators benötigt, erhält er den dazu erforderlichen hohen Vorspannstrom. Braucht der Komparator dagegen nur weniger schnelle oder weniger steile Eingangssignaländerungen zu verarbeiten, wird ihm auch ein geringerer Zusatzvorspannstrom zugeführt, was den mittleren Stromverbrauch besonders niedrig hält.

Eine technisch wenig aufwendige Lösung besteht in einer Zusatzstromquelle mit einer steuerbaren Stromquelle und einem zwischen den Signaleingang und einen Steuereingang der steuerbaren Stromquelle geschalteten Kondensator. Dabei wird dem Kondensator das Eingangssignal zugeführt. Bezeichnet man mit C den Kondensator, mit Ic den Kondensatorstrom, mit U das Eingangssignal und mit t die Zeit, erhält man einen Kondensatorstrom

$$Ic = dU/dt. \qquad\qquad (1)$$

Ic ist von null nur dann verschieden, wenn sich die Spannung U ändert, somit dU/dt von null verschieden ist.

Bei einer Ausführungsform eines erfindungsgemäßen Komparators mit einem Kondensator in der Zusatzstromquelle empfiehlt es sich, zwei Stromquellen mit je einem Kondensator zu verwenden, wobei eine erste Stromquelle und ein erster Kondensator einen Zusatzstrom nur während positiv gerichteter Eingangssignaländerungen und eine zweite Stromquelle und ein zweiter Kondensator Zusatzstrom nur während negativ gerichteter Eingangssignaländerungen liefern. Würde man sowohl für positiv gerichtete als auch für negativ gerichtete Eingangssignaländerungen ein und denselben Kondensator verwenden, würde dieser während Eingangssignaländerungen in der einen Richtung in gewünschter Weise Strom aus der Eingangssignalquelle ziehen, müßte aber bei Eingangssignaländerungen in der anderen Richtung einen Strom aus der Ruhestromquelle ziehen.

Bei einer Ausführungsform der Erfindung, deren Zusatzstromquelle mit einem oder zwei Kondensatoren aufgebaut ist, weist die bzw. jede steuerbare Stromquelle einen Stromspiegel auf, der in einem Eingangszweig den Kondensatorstrom Ic erhält und diesen zum Vorspannungsstromanschluß des Differenzverstärkers spiegelt.

Der Differenzverstärker kann in an sich bekannter Weise mit weiteren Stromspiegeln aufgebaut sein.

Die Erfindung sowie weitere Aufgabenaspekte und Vorteile der Erfindung werden nun anhand einer Ausführungsform näher erläutert. In den Zeichnungen zeigen:

Fig. 1    ein Schaltbild einer Ausführungsform eines erfindungsgemäßen Komparators;
Fig. 2    ein Beispiel einer Eingangssignalform; und
Fig. 3    ein Beispiel eines Kondensatorstroms, der in Fig. 1 gezeigten Schaltung.

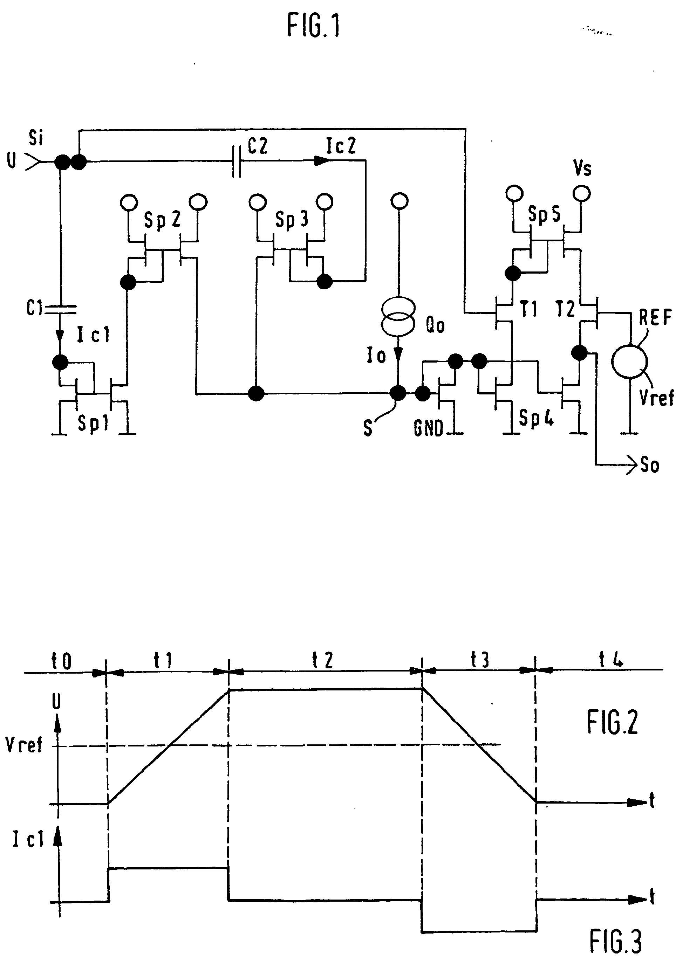

Fig. 1 zeigt ein Schaltbild einer Ausführungsform eines erfindungsgemäßen Komparators mit einer Vorspannstromquelle, die erfmdungsgemäß eine Ruhestromquelle und eine Zusatzstromquelle umfaßt.

In an sich bekannter Weise weist der in Fig. 1 gezeigte Komparator eine Differenzverstärkerstufe mit zwei Transistoren T1 und T2 auf. Gateanschlüsse dieser beiden Transistoren sind mit einem Signaleingang Si des Komparators verbunden, dem ein Eingangssignal U zugeführt wird. Ein Ausschnitt eines Beispiels für ein solches Eingangssignal U ist in Fig. 2 gezeigt. Der Gateanschluß des Transistors T2 ist mit einer Referenzspannungsquelle REF verbunden, welche dem Gateanschluß von T2 eine Referenzspannung Vref zuführt.

Alle Leitungen in Fig. 1, die mit einem Kreis abgeschlossen sind, sind mit einer Hochpotentialseite Vs, und alle Leitungen in Fig. 1, die mit einem Querstrich abgeschlossen sind, sind mit einer Niederpotentialseite GND einer Versorgungsspannungsquelle verbunden.

In ebenfalls an sich bekannter Weise befinden sich die beiden Transistoren T1 und T2 der Differenzverstärkerstufe zwischen einem hochpotentialseitigen Stromspiegel Sp5 und einem niederpotentialseitigen Stromspiegel Sp4. Die Differenzverstärkerstufe T1, T2 und die Stromspiegel Sp4, Sp5 bilden einen Differenzverstärker. Dieser weist einen Vorspannungsstromanschluß S auf, der gleichzeitig einen Stromsummierungspunkt der Schaltung bildet. Mit S ist eine Ruhestromquelle $Q_0$ verbunden, die an den Vorspannstromanschluß S einen Ruhestrom $I_0$ liefert, der einen Ruhevorspannstrom darstellt.

An den Vorspannstromanschluß S ist außerdem eine Zusatzstromquelle angeschlossen, welche erfindungsgemäß einen Zusatzstrom in den Vorspannungsstromanschluß S nur jeweils während Zeitabschnitten einspeist, in welchen sich das Eingangssignal U ändert. Die Zusatzstromquelle umfaßt zwei Zusatzstromstufen. Eine erste Zusatzstromstufe umfaßte einen ersten Kondensator C1, einen ersten Stromspiegel Sp1 und einen zweiten Stromspiegel Sp2. Die zweite Zusatzstromstufe umfaßt einen zweiten Kondensator C2 und einen dritten Stromspiegel Sp3. Dabei bilden die Stromspiegel Sp1 und Sp3 je eine steuerbare Stromquelle. Die Steuerung dieser Stromquellen erfolgt mit einem Kondensatorstrom Ic1 des ersten Kondensators C1 bzw. mit einem Kondensatorstrom Ic2 des zweiten Kondensators C2.

Sämtliche Stromspiegel Sp1 bis Sp5 sind in bekannter Weise je mit einem Diodenzweig in Form eines als Diode geschalteten Transistors und einem Transistorzweig aufgebaut, und zwar in der in Fig. 1 gezeigten wohlbekannten Weise, so daß eine ausführlichere Erläuterung hinsichtlich des Aufbaus und der Wirkung dieser Stromspiegel hier nicht erforderlich ist. In an sich ebenfalls bekannter Weise ist der niederpotentialseitige Stromspiegel Sp4 des Differenzverstärkers mit drei Stromspiegelzweigen aufgebaut. Ein Verbindungspunkt zwischen dem Transistor T2 und dem Stromspiegel Sp4 bildet den Ausgangsanschluß So des Komparators.

Die erste Zusatzstromstufe C1, Sp1, Sp2 dient dazu, in den Vorspannstromanschluß S jeweils dann einen Zusatzstrom einzuspeisen, wenn sich das Eingangssignal U gerade in positiver Richtung oder in Richtung zunehmenden Potentials ändert. Die zweite Zusatzstromquelle C2, Sp3 dient dazu, in den Vorspannstromanschluß S einen Zusatzstrom jeweils dann zu liefern, wenn sich das Eingangssignal U gerade in negativer Richtung oder in Richtung abnehmenden Potentials ändert. Da in beiden Fällen der Zusatzstrom aus der das Eingangssignal U liefernden Signalquelle gezogen und in den Vorspannstromanschluß S hineingeliefert werden soll, weist die erste Zusatzstromstufe zwei hintereinander geschaltete Stromspiegel Sp1 und Sp2 auf, wobei sich Sp1 auf der Niederpotentialseite und Sp2 auf der Hochpotentialseite der Versorgungsspannungsquelle befindet.

Es wird nun die Funktionsweise der in Fig. 1 gezeigten Komparatorschaltung erläutert, wobei ein Eingangssignal U des in Fig. 2 bspw. dargestellten Signalverlaufs angenommen wird.

In Fig. 2 ist ein Eingangssignal U dargestellt, das in Zeitabschnitten t0, t2 und t4 einen konstanten niedrigen bzw. hohen Potentialverlauf aufweist und in den Zeitabschnitten t1 und t3 eine Anstiegsflanke bzw. eine Abfallflanke aufweist.

Die beiden Kondensatoren C1 und C2 führen zu einem Strom

$$Ic1 = C1 \cdot dU/dt \qquad\qquad (2)$$

$$Ic2 = C2 \cdot dU/dt \qquad\qquad (3)$$

Während der Zeitabschnitte t0, t2 und t4 ist dU/dt = 0, während dU/dt während der Zeitabschnitte t1 und t3 einen positiven bzw. negativen Wert annimmt. Dies ist in Fig. 3 für den Kondensatorstrom Ic1 des ersten Kondensators C1 dargestellt.

Währen der Zeitabschnitte t0, t2 und t4, die man als Ruheabschnitte bezeichnen kann, sind die Kondensatorströme Ic1 und Ic2 somit beide gleich 0.

Der Stromspiegel Sp1 wird nur von einem positiven Kondensatorstrom Ic1 leitend gesteuert, während er einen negativen Kondensatorstrom Ic1 sperrt. Umgekehrt wird der Stromspiegel Sp3 nur von einem negativen Kondensatorstrom Ic2 leitend gesteuert, während er einen positiven Kondensatorstrom Ic2 sperrt.

Während der Zeitabschnitte t0 bis t4 findet somit folgende Vorspannstromeinspeisung in den Vorspannstromanschluß S statt:

Während der Zeitabschnitte t0, t2 und t4 wird nur der Ruhestrom $I_0$ der Konstantstromquelle $Q_0$ eingespeist. Während des Zeitabschnitts t1 liefert der zuvor aufgeladene erste Kondensator C1 über die Stromspiegel Sp1 und Sp2 an den Vorspannstromanschluß S einen Strom entsprechend Ic1. Während des Zeitabschnittes t3 liefert der zuvor aufgeladene zweite Kondensator C2 über den Stromspiegel Sp3 an den Vorspannstromanschluß S einen Strom entsprechend Ic2.

Generell ausgedrückt funktioniert die erfmdungsgemäße Vorspannstromquelle somit in der Weise, daß dem Differenzverstärker über den Vorspannstromanschluß S ein Vorspannstrom zuführbar ist, der in Abhängigkeit davon, ob das Eingangssignal U gerade konstant oder veränderlich ist, eine niedrige Ruhestromstärke $I_0$ oder eine höhere Aktivstromstärke von etwa $I_0$ + Ic1 bzw. $I_0$ + Ic2 aufweist.

Stellt der Signaleingang Si des Komparators bspw. einen Anschluß an einen Bus dar und handelt es sich bei dem Eingangssignal U um ein Bussignal, das mittels des Komparators gemäß Fig. 1 bewertet werden soll, werden die Zeitanteile, während welcher Flanken auftreten, im Mittel relativ klein sein, insbesondere für Bussysteme, die zwischen Aktivitätszeiten relativ lange Ruhezeiten aufweisen. Mit der Erfindung ist das Ziel verwirklicht worden, während dieser Ruhezeiten, die in praktischen Fällen den größten Zeitanteil haben, einen sehr niedrigen Stromverbrauch des Komparators zu erzielen. Daß während der aktiven Busphasen, also zu Flankenzeiten des Eingangssignals U, ein höherer Stromverbrauch auftritt, ist praktisch unerheblich im Hinblick auf den geringen mittleren Zeitanteil solcher Flanken. Mit der Erfindung ist es somit gelungen, den mittleren Stromverbrauch des Komparators durch Reduzierung des Ruhe-Vor- spannstroms $I_0$ auf beispielsweise einige μA sehr niedrig zu halten und den Komparator trotzdem während der entscheidenden Zeitabschnitte der Eingangssignalflanken schnell zu machen.

Die in Fig. 1 dargestellte Ausführungsform eines erfindungsgemäßen Komparators mit den Kondensatoren C1 und C2 hat den zusätzlichen Vorteil, daß der Kondensatorstrom Ic1 bzw. Ic2 umso höher wird, je steiler die jeweilige Flanke des Eingangssignals U ist. D.h., je steiler die Flanke, desto schneller wird der Komparator. Denn dem Vorspannstromanschluß S wird mit zunehmender Flankensteilheit ein entsprechend zunehmender Zusatzstrom aus der Zusatzstromquelle geliefert.

Bei der in Fig. 1 gezeigten Ausführungsform eines erfindungsgemäßen Komparators sind sämtliche Transistoren als MOS-Transistoren ausgebildet. Von welchem Kanal-Typ die einzelnen Transistoren sind, hängt von der Polung der Versorgungsspannungsanschlüsse ab. Es ist allerdings auch möglich, eine entsprechende Schaltung ganz oder mindestens teilweise mit Bipolartransistoren aufzubauen.

**Patentansprüche**

1.  Komparator

    mit einem Differenzverstärker (T1, T2, Sp4, Sp5), der einen mit einem Eingangssignal (U) beaufschlagbaren Signaleingang und einen mit einer Referenzspannung (Vref) beaufschlagbaren Referenzeingang aufweist,
    und mit einer steuerbaren Vorspannstromquelle (Q$_0$, C1, C2, Sp1, Sp2, Sp3), mittels welcher dem Differenzverstärker (T1, T2, Sp4, Sp5) ein Vorspannstrom zuführbar ist, der in Abhängigkeit davon, ob das Eingangssignal (U) gerade konstant oder veränderlich ist, eine niedrige Ruhestromstärke (I$_0$) oder eine höhere Aktivstromstärke aufweist.

2.  Komparator nach Anspruch 1, bei welchem die Vorspannstromquelle aufweist:

    eine einen konstanten Ruhestrom (I$_0$) liefernde Konstantstromquelle (Q$_0$)
    und eine nur während Zeiten (t1, t3) einer Eingangssignaländerung einen Zusatzstrom liefernde Zusatzstromquelle (C1, C2, Sp1 bis Sp3).

3.  Komparator nach Anspruch 2, bei welchem der Differenzverstärker (T1, T2, Sp4, Sp5) einen Vorspannstromanschluß (S) aufweist, mit dem sowohl ein Ausgangsanschluß der Konstantstromquelle (Q$_0$) als auch ein Ausgangsanschluß der Zusatzstromquelle (C1, C2, Sp1 bis Sp3) verbunden ist.

4.  Komparator nach Anspruch 2 oder 3, bei welchem die Zusatzstromquelle (C1, C2, Sp1 bis Sp3) einen Zusatzstrom liefert, dessen Stromstärke von der Stärke der zeitlichen Eingangssignaländerung abhängt.

5.  Komparator nach Anspruch 4, bei welchem die Zusatzstromquelle (C1, C2, Sp1 bis Sp3) eine steuerbare Stromquelle (Sp1, Sp3) und einen zwischen den Signaleingang (Si) und einen Steuereingang der steuerbaren Stromquelle (Sp1, Sp3) geschalteten Kondensator (C1, C2) aufweist.

6.  Komparator nach Anspruch 5, bei welchem die Zusatzstromquelle (C1, C2, Sp1 bis Sp3) aufweist:

    einen ersten Kondensator (C1) und eine erste steuerbare Stromquelle (Sp1), welche einen Zusatzstrom nur bei sich in positiver Richtung ändernden Eingangssignal (U) liefert,
    und einen zweiten Kondensator (C2) und eine zweite steuerbare Stromquelle (Sp3), welche Zusatzstrom nur bei sich in negativer Richtung änderndem Eingangssignal (U) liefert.

7.  Komparator nach Anspruch 5 oder 6, bei welchem die bzw. jede steuerbare Stromquelle (Sp1, Sp3) einen zwischen den Kondensator (C1, C2) und den Vorspannstromanschluß (S) geschalteten Stromspiegel (Sp1, Sp3) aufweist, der einen ihm vom Kondensator (C1, C2) gelieferten Kondensatorstrom (Ic1, Ic2) zum Vorspannstromanschluß (S) spiegelt.

8.  Komparator nach Anspruch 7,
    bei welchem die erste steuerbare Stromquelle zwei hintereinander geschaltete Stromspiegel (Sp1, Sp2) aufweist, von denen ein mit dem ersten Kondensator (C1) gekoppelter erster Stromspiegel (Sp1) auf einer Niederpotentialseite (GND) und ein mit dem Vorspannstromanschluß (S) gekoppelter zweiter Stromspiegel (Sp2) auf einer Hochpotentialseite (VS) einer Versorgungsspannungsquelle angeordnet ist, und bei welchem die zweite steuerbare Stromquelle (SP3) einen auf der Hochpotentialseite (VS) der Versorgungsspannungsquelle angeordneten, zwischen den zweiten Kondensator (C2) und den Vorspannstromanschluß (S) geschalteten dritten Stromspiegel (Sp3) aufweist.

9.  Komparator nach einem der Ansprüche 1 bis 8, bei welchem der Differenzverstärker (T1, T2, Sp4, Sp5) eine Differenzstufe mit zwei Differenzstufentransistoren (T1, T2) aufweist, die zwischen einen hochpotentialseitigen vierten Stromspiegel (Sp5) und einen niederpotentialseitigen fünften Stromspiegel (Sp4) geschaltet sind, von denen einer (Sp4) einen Stromspiegelzweig aufweist, in den ein Strom einspeisbar ist, der von dem Vorspannstrom abhängt, der von der steuerbaren Vorspannstromquelle (Q$_0$, C1, C2, Sp1-Sp3) geliefert wird.

**Revendications**

1.  Comparateur comportant un amplificateur différentiel T1, T2, Sp4, Sp5 qui présente une entrée de signaux pouvant recevoir un signal d'entrée U et une entrée de référence pouvant recevoir une tension de référence Vref, et comportant une source de courant de précontrainte Qo, C1, C2, Sp1, Sp2, Sp3 au moyen de laquelle on peut envoyer à l'amplificateur différentiel P1, P2, Sp4, Sp5 un courant de précontrainte qui, suivant que le signal d'entrée U est constant ou variable, présente une faible intensité de repos $I_0$ ou une grande intensité active.

2.  Comparateur selon la revendication 1, dans lequel la source de courant de précontrainte présente une source de courant constant $Q_0$ fournissant un courant de repos constant $I_0$, et une source de courant additionnel C1, C2, Sp1 à Sp3 ne fournissant un courant additionnel que pendant les temps t1, t3 d'une variation du signal d'entrée.

3.  Comparateur selon la revendication 2, dans lequel l'amplificateur différentiel T1, T2, Sp4, Sp5 comporte un raccord de courant de précontrainte S auquel sont reliés un raccord de sortie de la source de courant constant $Q_0$ de même qu'un raccord de sortie de la source de courant additionnel C1, C2, Sp1 à Sp3.

4.  Comparateur selon la revendication 2 ou 3, dans lequel la source de courant additionnel C1, C2, Sp1 à Sp3 fournit un courant additionnel dont l'intensité dépend de l'intensité de la variation dans le temps du signal d'entrée.

5.  Comparateur selon la revendication 4, dans lequel la source de courant additionnel C1, C2, Sp1 à Sp3 comporte une source de courant commandable Sp1, Sp3 et un condensateur C1, C2 couplé entre l'entrée de signaux Si et une entrée de commande de la source de courant commandable Sp1, Sp3.

6.  Comparateur selon la revendication 5, dans lequel la source de courant additionnel C1, C2, Sp1 à Sp3 comporte : un premier condensateur C1 et une première source de courant commandable Sp1 qui fournit un courant additionnel uniquement lorsque le signal d'entrée U varie dans le sens positif, et un deuxième condensateur C2 ainsi qu'une deuxième source de courant commandable Sp3 qui ne fournit un courant additionnel que lorsque le signal d'entrée U varie dans le sens négatif.

7.  Comparateur selon la revendication 5 ou 6, dans lequel la ou chaque source de courant commandable Sp1, Sp3 comporte un miroir de courant Sp1, Sp3 couplé entre le condensateur C1, C2 et le raccord de courant de précontrainte S, lequel réfléchit un courant de condensateur Ic1, Ic2, qui lui est fourni par le condensateur C1, C2, vers le raccord de courant de précontrainte S.

8.  Comparateur selon la revendication 7, dans lequel la première source de courant commandable comporte deux miroirs de courant Sp1, Sp2 couplés l'un derrière l'autre, dont un premier miroir de courant Sp1, couplé avec le premier condensateur C1, est disposé sur un côté bas potentiel (GND) et un deuxième miroir de courant Sp2, couplé au raccord de courant de précontrainte S, est disposé sur un côté haut potentiel (VS) d'une source de tension d'alimentation, et dans lequel la deuxième source de courant commandable Sp3 comporte un troisième miroir de courant Sp3 disposé sur le côté haut potentiel VS de la source de tension d'alimentation, et couplé entre le deuxième condensateur C2 et le raccord de courant de précontrainte S.

9.  Comparateur selon l'une des revendications 1 à 8, dans lequel l'amplificateur différentiel T1, T2, Sp4, Sp5 comporte un étage différentiel avec deux transistors d'étage différentiel T1, T2 qui sont couplés entre un quatrième miroir de courant Sp5 côté haut potentiel et un cinquième miroir de courant Sp4 côté bas potentiel dont un Sp4 comporte une branche de miroir de courant dans laquelle on peut introduire un courant qui dépend du courant de précontrainte et qui est fourni par la source de courant de précontrainte commandable $Q_0$, C1, C2, Sp1-Sp3.

**Claims**

1.  A comparator comprising
    a differential amplifier (T1, T2, Sp4, Sp5) with a signal input to which an input signal (U) can be applied and a reference input to which a reference voltage (Vref) can be applied, and
    a controllable bias current source (Qo, C1, C2, Sp1, Sp2, Sp3) for supplying to the differential amplifier (T1, T2, Sp4, Sp5) a bias current which has a low quiescent current strength (Io) or a higher active current strength as a function of whether the input signal (U) is constant or variable at the moment.

**2.** A comparator according to claim 1, wherein the bias current source has:

a constant current source (Qo) supplying a constant quiescent current (Io), and an additional current source (C1, C2, Sp1 to Sp3) supplying an additional current only during times (t1, t3) of input signal variation.

**3.** A comparator according to claim 2, wherein the differential amplifier (T1, T2, Sp4, Sp5) has a bias current terminal (S) with which both an output terminal of the constant current source (Qo) and an output terminal of the additional current source (C1, C2, Sp1 to Sp3) are connected.

**4.** A comparator according to claim 2 or 3, wherein the additional current source (C1, C2, Sp1 to Sp3) supplies an additional current whose current strength depends on the strength of the input signal variation in time.

**5.** A comparator according to claim 4, wherein the additional current source (C1, C2, Sp1 to Sp3) has a controllable current source (Sp1, Sp3) and a capacitor (C1, C2) connected between the signal input (Si) and a control input of the controllable current source (Sp1, Sp3).

**6.** A comparator according to claim 5, wherein the additional current source (C1, C2, Sp1 to Sp3) has:

a first capacitor (C1) and a first controllable current source (Sp1) which supplies an additional current only upon an input signal (U) varying in the positive direction, and
a second capacitor (C2) and a second controllable current source (Sp3) which supplies additional current only upon an input signal (U) varying in the negative direction.

**7.** A comparator according to claim 5 or 6, wherein the, or each, controllable current source (Sp1, Sp3) has a current mirror (Sp1, Sp3) connected between the capacitor (C1, C2) and the bias current terminal (S) for mirroring a capacitor current (Ic1, Ic2) supplied thereto from the capacitor (C1, C2) to the bias current terminal (S).

**8.** A comparator according to claim 7, wherein the first controllable current source has two series-connected current mirrors (Sp1, Sp2), a first current mirror (Sp1) coupled with the first capacitor (C1) being disposed on a low potential side (GND) of a supply voltage source, and a second current mirror (Sp2) coupled with the bias current terminal (S) being disposed on a high potential side (Vs) thereof, and wherein the second controllable current source (Sp3) has a third current mirror (Sp3) disposed on the high potential side (Vs) of the supply voltage source and connected between the second capacitor (C2) and the bias current terminal (S).

**9.** A comparator according to any of claims 1 to 8, wherein the differential amplifier (T1, T2, Sp4, Sp5) has a differential stage with two differential stage transistors (T1, T2) which are connected between a high potential side fourth current mirror (Sp5) and a low potential side fifth current mirror (Sp4), one of which (Sp4) has a current mirror branch into which a current can be fed which depends on the bias current supplied by the controllable bias current source (Qo, C1, C2, Sp1-Sp3).

# FIG.1

# FIG.2

# FIG.3